# DEMANDE DE BREVET EUROPEEN

(11) **EP 0 781 859 A1**
(43) Date de publication de la demande: **02.07.1997**
(21) Numéro de dépôt: 96402901.1
(22) Date de dépôt: 26.12.1996
(51) Int. Cl.: C23C 14/00, C23C 14/22, C23C 16/44, C23C 14/06

(54) **Procédé de depôt d'un revêtement**

(30) Priorité: 28.12.1995 FR 9515647
(71) Demandeur: COMMISSARIAT A L'ENERGIE ATOMIQUE, 75015 Paris Cédex 15 (FR)
(72) Inventeur: Danroc, Joel, 38100 Grenoble (FR); Juliet, Pierre, 38100 Grenoble (FR); Rouzaud, André, 38170 Seyssinet (FR)
(74) Mandataire: Poulin, Gérard

(57) **Abrégé**

La présente invention a trait à un procédé de dépôt d'un revêtement plus précisément un procédé de fabrication d'un revêtement anticorrosion et anti-usure de pièces métalliques, ce revêtement comprenant au moins une couche à gradient de composition déposée par mise en oeuvre simultanée des deux techniques de dépôt physique en phase vapeur "PVD" et de dépôt chimique en phase vapeur assisté par plasma "PACVD". La présente invention concerne également le revêtement ainsi obtenu ainsi que le substrat recouvert de ce revêtement qui peut être par exemple une tige d'amortisseur pour véhicules.

## Description

La présente invention a trait à un procédé de dépôt d'un revêtement plus précisément un procédé de fabrication d'un revêtement anticorrosion et anti-usure de pièces métalliques, ce revêtement comprenant au moins une couche à gradient de composition déposée par mise en oeuvre simultanée des deux techniques de dépôt physique en phase vapeur "PVD" et de dépôt chimique en phase vapeur assisté par plasma "PACVD". La présente invention concerne également le revêtement ainsi obtenu ainsi que le substrat recouvert de ce revêtement qui peut être par exemple une tige d'amortisseur pour véhicules.

Les pièces métalliques de toutes sortes réalisées notamment dans des métaux tels que le fer, l'acier et les alliages divers sont souvent sollicitées dans les conditions ambiantes courantes qui peuvent être parfois corrosives, comme cela peut se produire dans les atmosphères présentant un fort degré d'hygrométrie ou encore dans les atmosphères marines très chargées en sels corrosifs.

Ces pièces métalliques travaillent également parfois dans des milieux agressifs constitués par exemple par des fluides hydrauliques. C'est le cas notamment des vérins, des pièces de pelleteuses, des machines hydrauliques, des tiges d'amortisseurs qui ne sont pas forcément huilées, des supports de hayons d'automobiles, etc.

Ces pièces métalliques doivent donc présenter d'excellentes caractéristiques de dureté de surface, ainsi que de résistance à la corrosion et à l'usure.

Les procédés de durcissement de surface et d'amélioration de la résistance à la corrosion et à l'usure sont essentiellement des traitements par voie humide, comme par exemple le chromage électrolytique, que l'on applique généralement à des pièces cylindriques. De tels traitements posent des problèmes de respect de l'environnement du fait des effluents toxiques notamment chargés en chrome qu'ils génèrent et font l'objet de réglementations de plus en plus sévères, nécessitant la mise en place d'installations complexes et coûteuses de traitement de ces effluents, afin d'en éliminer les composés nocifs tels que les composés du chrome.

C'est ainsi que d'autres techniques de dépôt de revêtements et en particulier de revêtements anticorrosion et anti-usure ont été proposées parmi lesquelles on peut citer la technique de projection d'un revêtement à l'aide d'un plasma, par exemple à base de nickelure de chrome-NiCr et de carbure de chrome-Cr₃C₂, ou bien encore les techniques de dépôt physique en phase vapeur, encore dénommées "PVD", ou "Physical vapour Deposition," dans les ouvrages en langue anglaise.

Les dépôts élaborés par plasma sont épais car ils présentent une épaisseur minimum de 150µm et rugueux, avec une rugosité minimale de 8µm ; ils sont également peu étanches, donc résistant mal à la corrosion. Ils nécessitent de plus des reprises d'usinage.

Les dépôts réalisés par PVD et en particulier par pulvérisation cathodique magnétron sont réalisés généralement à base de chrome. Ce procédé présente l'intérêt d'être réalisable sur des pièces de cotes finies et donc de ne pas nécessiter d'usinage complémentaire. Les essais réalisés notamment à partir de dépôts de Cr-C montrent une amélioration sensible par rapport au chromage classique surtout pour ce qui est de la résistance à l'usure.

La limitation des revêtements élaborés par PVD se situe dans le domaine de la résistance à la corrosion, comme cela est indiqué par exemple dans l'Article de F. ELSTNER, F. NARDOU, G. CONTOUX, F. COSSET, J. MACHET paru dans un supplément à la Revue "Le Vide : science, technique et applications" N° 275-Janvier-Février-Mars 1995, p. 230-233 et intitulé "Residual Stress in Thin Chromium Films Deposited by DC Magnetron Sputtering and its influence on the Corrosion Resistance".

Les revêtements PVD ont donc un bon comportement anti-usure, mais cette technique d'élaboration ne permet en aucun cas la réalisation de couches étanches.

Une autre technique voisine de la technique PVD est la technique connue habituellement sous le nom de « PVD réactif ».

Ainsi, le document DE-A-4 343 354 décrit-il un procédé de préparation d'un revêtement dur sur une pièce. Ce revêtement comprend une couche dite couche adhérente, une couche dite couche fonctionnelle, et enfin une couche de surface.

Les couches sont déposées par évaporation à partir d'une source métallique solide par exemple en titane ou en borure de titane, les vapeurs métalliques produites réagissant avec un gaz réactif carboné par exemple de l'acétylène, ou de l'azote, pendant leur transport ou au niveau du substrat.
Le procédé décrit dans ce document est effectivement un procédé dit de « PVD réactif » et non un « procédé associant les techniques de CVD (dépôt chimique en phase vapeur) et de PVD » selon l'appellation utilisée à tort à la page 2, lignes 35 à 40 de ce document DE-A-4 343 354.

De même, le document EP-A-0 0 307 675 concerne-t-il une amélioration aux procédés PVD dans lesquels la vapeur métallique n'est pas créée par évaporation classique mais par évaporation par Arc, qui présente l'avantage de créer de la vapeur métallique très ionisée et donc de permettre l'élaboration de revêtements particulièrement adhérents. Cette amélioration consiste à réaliser l'évaporation par Arc de cibles métalliques notamment en Titane, en présence de gaz réactifs.

Une telle technique qui est effectivement une technique de « PVD réactif » conduit à des dépôts très adhérents et présentant un bon comportement à l'usure, mais dont le comportement anticorrosion est notoirement insuffisant.

En revanche, la technique de dépôt chimique en phase vapeur, encore dénommée CVD, abréviation de "Chemical Vapour Deposition," dans les ouvrages en langue anglaise, est parfaitement adaptée à l'obtention de dépôts étanches.

En particulier, la technique de dépôt chimique en phase vapeur assisté par plasma, encore dénommée PACVD, abréviation de "Plasma-Assisted Chemical Vapour Deposition" dans les ouvrages en langue anglaise, permet l'élaboration de dépôts à température ambiante, ce qui constitue un avantage considérable dans la mesure où, d'une part, les risques d'oxydation du substrat lui-même scnt évités et, d'autre part, les revêtements PVD déjà élaborés sur le substrat ne subissent pas d'élévation de température, de ce fait il n'y a pas d'oxydation ni de changement de texture possibles du revêtement en PVD se trouvant déjà sur le substrat. Une oxydation in situ du substrat ou des dépôts PVD ainsi qu'un changement de texture pourrait en effet s'avérer très préjudiciable au niveau des propriétés anticorrosion et anti-usure des revêtements.

La superposition de revêtements élaborés par des techniques différentes comme le sont le PVD ou le PVD réactif et le PACVD pose néanmoins des problèmes d'adhérence et de défauts de croissance de couches, ces problèmes pouvant avoir des effets néfastes sur le comportement des revêtements lors de leur utilisation dans des conditions réelles, il peut se produire par exemple une délamination du dépôt.

Il existe donc un besoin non encore satisfait pour un procédé de fabrication permettant d'obtenir des revêtements ayant d'excellentes propriétés de résistance à l'usure et d'excellentes propriétés d'étanchéité et de résistance à la corrosion, ces revêtements présentant également une excellente adhérence au substrat et présentant aussi-lorsque le revêtement comporte plusieurs couches - une excellente adhérence des couches entre elles.

L'objet de l'invention est donc de fournir un procédé de dépôt d'un revêtement sur un substrat, et en particulier un procédé de fabrication d'un revêtement anticorrosion et anti-usure de pièces métalliques qui apporte une solution aux problèmes présentés par les procédés de l'art antérieur et qui répondent entre autres aux besoins mentionnés plus haut.

La présente invention a ainsi pour objet un procédé de dépôt d'un revêtement sur un substrat caractérisé en ce que ce revêtement comprend au moins une couche à gradient de composition déposée par mise en oeuvre simultanée des deux techniques de dépôt physique en phase vapeur PVD et de dépôt chimique en phase vapeur assisté par plasma PACVD. De façon plus précise, la présente invention a pour objet un procédé de fabrication d'un revêtement multicouches qui comprend en outre des couches déposées par dépôt chimique en phase vapeur assisté au plasma (PACVD), et des couches déposées par dépôt physique en phase vapeur (PVD).

L'invention s'applique en particulier, mais non exclusivement à la fabrication d'un revêtement anticorrosion et anti-usure, en particulier de pièces métalliques, notamment de tiges d'amortisseurs pour véhicules.

D'autres caractéristiques et avantages de l'invention ressortiront mieux de la description qui suit, donnée à titre purement illustratif, mais non limitatif en référence aux figures annexées sur lesquelles :

La figure 1 représente une enceinte conforme à l'invention pour le dépôt de couches à gradient de composition par mise en oeuvre simultanée des deux techniques PVD et PACVD.

La figure 2 représente une enceinte de dépôt utilisée pour l'élaboration des dépôts durs anti-usure par la technique de dépôt physique en phase vapeur ou PVD.

La figure 3 représente une enceinte de dépôt utilisée pour l'élaboration des dépôts étanches, anticorrosion par la technique de dépôt chimique en phase vapeur assisté par plasma encore dénommée PACVD.

La figure 4 représente un exemple d'une installation permettant l'élaboration de revêtements multicouches complexes comprenant une pluralité de couches dont l'une au moins est une couche à gradient de composition selon l'invention, réalisée par mise en oeuvre simultanée des deux techniques PVD et PACVD.

Selon l'invention, le procédé consiste à déposer un revêtement sur un substrat, au moins une couche de ce revêtement étant une couche à gradient de composition déposée par mise en oeuvre simultanée des deux techniques de dépôt physique en phase vapeur PVD et de dépôt chimique en phase vapeur assisté par plasma PACVD. Par mise en oeuvre simultanée ou encore « couplage », on entend généralement que le procédé selon l'invention associe les deux techniques de dépôt mentionnées ci-dessus qui sont mises en oeuvre de manière concomitante et en même temps, de façon à ce que, par exemple, le plasma créé lors de la réalisation du dépôt par PVD par des dispositifs adéquats tels que des magnétrons, servent à la décomposition des précurseurs du dépôt utilisés dans la technique PACVD. De même, par couche à gradient de composition, on entend une couche présentant une variation généralement progressive et continue de sa composition tout au long de son épaisseur, depuis une composition correspondant par exemple à une couche PACVD pure jusqu'à une composition correspondant par exemple à une couche PVD pure, ou vice versa, ce gradient étant de préférence obtenu en faisant varier, par exemple de manière progressive et continue ou par incrément la densité de puissance mise en oeuvre par la technique PVD et/ou en modifiant la nature des précurseurs du dépôt pour la technique PACVD utilisés au cours du dépôt.

Cette couche à gradient de composition spécifique de la présente invention préparée par mise en oeuvre simultanée des deux techniques PVD et PACVD apporte une solution satisfaisante aux problèmes des revêtements de l'art antérieur tels qu'ils sont mentionnés ci-dessus. En effet, ces couches de revêtement à gradient de composition qui sont généralement des couches intermédiaires entre une couche PVD et une couche PACVD permettent notamment un passage progressif entre les couches élaborées par les différentes techniques, ce qui limite ainsi les risques de décollement et les défauts de croissance. De ce fait, il est possible grâce à la présente invention d'obtenir des revêtements à la fois durs et étanches comprenant au moins une couche obtenue par mise en oeuvre simultanée des techniques PACVD/PVD, ainsi que éventuellement d'autres couches telles que des couches PVD et PACVD pures, qui présentent aussi bien d'excellentes propriétés anti-usure que d'excellentes propriétés anticorrosion avec une excellente adhésion des couches entre elles et au substrat.

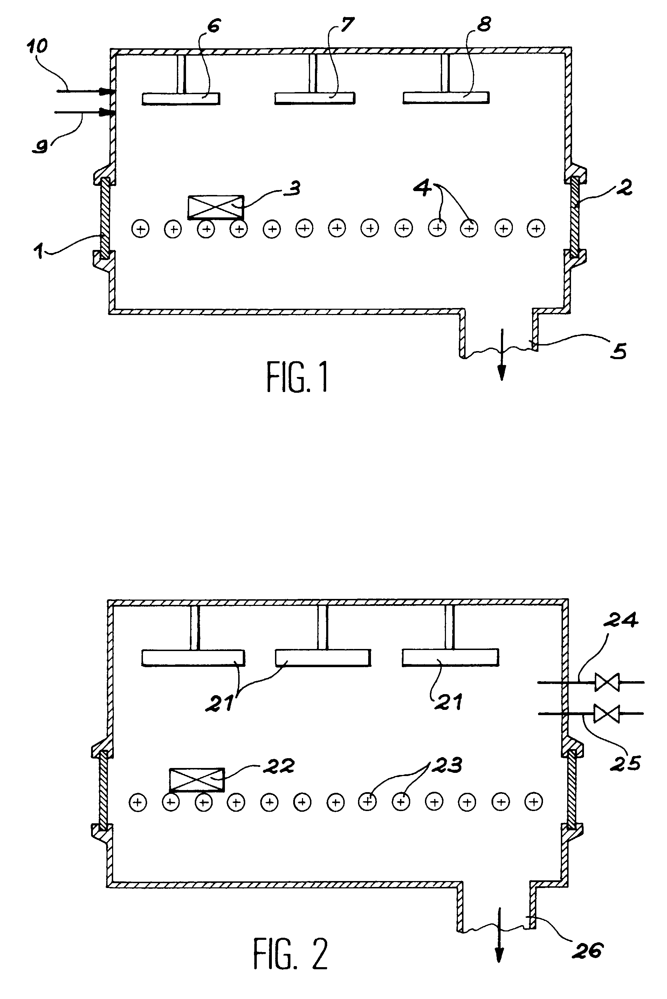

Sur la figure 1, on a représenté un dispositif pour la mise en oeuvre du procédé selon l'invention et permettant le dépôt sur un substrat d'au moins une couche à gradient élaborée par mise en oeuvre simultanée des deux techniques PVD et PACVD.

Selon l'invention, les couches à gradient qui peuvent être des couches intermédiaires entre par exemple les couches étanches réalisées par la technique PACVD et les couches dures réalisées par la technique PVD sont réalisées de préférence dans une enceinte spéciale "au défilé" représentée sur la Fig. 1.

Le ou les substrat(s) sont introduits dans l'enceinte par l'orifice d'entrée (1) et en sortent revêtus par l'orifice de sortie (2).

Le ou les substrat(s) (3) qui peuvent être revêtus par le procédé de l'invention sont de préférence des substrats en métal, tel que aciers au carbone ou aciers inox ou alliages légers tels que alliage d'aluminium. Mais des substrats en d'autres matériaux tels que matériaux plastiques ou composites peuvent également être revêtus par le procédé selon l'invention associant les techniques PVD et PACVD. Ce substrat peut prendre une forme quelconque, mais il est de préférence constitué par des pièces usinées, finies, par exemple des tiges d'amortisseurs pour automobiles, des vérins, etc. De même, il est possible de ne revêtir qu'une partie de la surface du substrat, une autre partie n'étant pas revêtue ou bien revêtue d'un dépôt de nature différente.

Selon un aspect préféré de l'invention, le procédé est réalisé en continu, c'est-à-dire que le ou les substrat(s) à revêtir sont acheminés depuis l'entrée jusqu'à la sortie de l'enceinte par un dispositif de transport adéquat ou porte-échantillons, mobile de préférence dans les deux sens.

Ce dispositif permet par exemple le transport des substrats en translation-rotation. Ce dispositif peut en particulier consister en des rouleaux (4) associés à un système de sas différentiel ou autre leur assurant une vitesse constante, par exemple de 0,001 à 0,1 m/sec. depuis l'entrée jusqu'à la sortie de l'enceinte.

Il est bien évident que le procédé peut également être réalise en mode discontinu "batch". C'est en particulier le cas lorsque le substrat ne doit recevoir qu'une seule couche déposée par mise en oeuvre simultanée de deux techniques PVD/PACVD.

Cette enceinte est équipée comme l'enceinte destinée à la réalisation des couches dures PVD d'un système de pompage turbo ou d'une pompe à diffusion raccordée par un tube à l'enceinte (5) et permettant d'assurer une pression de travail, de préférence de 0,5 à 5 Pa. Cette enceinte comprend plusieurs dispositifs (6), (7), (8) permettant d'assurer le dépôt PVD, de préférence des magnétrons ou bien encore des évaporateurs à faisceau d'électrons. Le nombre de magnétrons ou d'autres dispositifs analogues permettant d'assurer un dépôt de type PVD est variable et peut facilement être déterminé par l'homme du métier, afin d'obtenir un gradient de composition plus ou moins progressif sur l'ensemble de l'épaisseur du dépôt, ce nombre varie par exemple de 2 à 10. Il est de préférence compris entre 2 et 5. Ces magnétrons (6), (7), (8) sont équipés de préférence de cibles analogues à celles utilisées dans l'enceinte permettant l'élaboration des revêtements durs anti-usure par la technique du dépôt physique en phase vapeur PVD qui est décrite plus loin, c'est-à-dire que ce sont des cibles ayant déjà la composition souhaitée du dépôt, par exemple la cible peut être constituée de CrC ou d'un matériau de type céramique.

La densité de puissance appliquée aux différents magnétrons - à savoir P₁, P₂, P₃ depuis l'entrée vers la sortie - est différente : par exemple, elle peut croître depuis l'entrée (1) où le substrat non traité pénètre dans l'enceinte jusqu'à la sortie (2) de l'enceinte, où l'on récupère un substrat recouvert du dépôt selon l'invention, c'est-à-dire que dans ce cas P₁ < P₂ < P₃ ; mais cette densité de puissance peut aussi décroître depuis l'entrée jusqu'à la sortie de l'enceinte. Dans ce cas, la couche déposée aura tout d'abord au voisinage de l'entrée une composition voisine d'un dépôt PVD pur tandis que près de la sortie, la composition de la couche déposée sera quasiment celle d'un dépôt PCVD pur. La densité de puissance appliquée aux divers magnétrons peut varier entre de larges limites, le magnétron de plus faible densité de puissance (6) aura par exemple une densité de puissance comprise entre 0,1 et 1 W/cm², et le magnétron de plus forte densité de puissance (8) aura par exemple une densité de puissance comprise entre 5 et 30 W/cm².

La densité de puissance appliquée aux magnétrons intermédiaires ainsi que leur nombre (voir ci-dessus) dépend de la progressivité du gradient que l'on souhaite appliquer.

Ainsi, par exemple, comme représenté sur la figure 1, lorsque trois magnétrons sont présents dans l'enceinte, la densité de puissance respective appliquée à ces trois magnétrons peut être de 1 W/cm⁻², 5 W/cm² et 10 W/cm². Le flux de vapeur correspondant varie donc dans le rapport 1, 5 et 10 au niveau des trois magnétrons. Les substrats se déplaçant par exemple "au défilé" depuis la gauche vers la droite sur la figure 1 recevront donc lors de leur passage sous les différents magnétrons des flux variables d'atomes du type décrit dans la liste des matériaux déjà donnés ci-dessus dans le cadre des dépôts par PVD.

Comme cela est le cas dans un procédé PVD classique, un gaz de décharge, généralement de l'Argon, est introduit dans l'enceinte en (9) ; le groupe de pompage qui a servi à faire le vide dans l'enceinte maintient une pression constante de gaz dans l'enceinte tout en assurant une circulation et un renouvellement permanent de ce gaz.

Conformément à l'invention, et afin d'obtenir la mise en oeuvre simultanée des deux techniques PACVD et PVD souhaitée, on envoie en même temps dans l'enceinte par l'orifice (10) des précurseurs qui sont ceux décrits plus loin dans la partie relative à l'élaboration des couches étanches par PACVD.

Ces précurseurs, selon l'invention qui associe les techniques PVD et PACVD, vont se décomposer par exemple dans le plasma créé par le magnétron mis en oeuvre dans la technique PVD et ainsi un flux de vapeur va-t-il se condenser sur le substrat. Ce flux de vapeur est généralement, et en principe constant. Les matériaux créés par ces précurseurs sont des matériaux par exemple du type oxyde de métal ou de métalloïde tels que SiO₂, Al₂O₃, ZrO₂, TiO₂, HfO₂, oxydes de vanadium ou des polymères de type "plasma" comme décrit par exemple par Yasuda, dans H. Plasma Polymerization, A.C. Press; London 1985, chapitre VI. On voit donc que, conformément à l'invention, et selon la position des substrats sous les différents magnétrons, le rapport des atomes couches dures, couches étanches varie. Le dépôt sous le magnétron de forte densité de puissance se rapprochera plutôt des couches dures, c'est-à-dire que sous ce magnétron on aura un dépôt quasiment analogue à celui obtenu par mise en oeuvre de la technique PVD pure, tandis que le dépôt sous le magnétron de faible densité de puissance se rapprochera plutôt des couches étanches, c'est-à-dire que sous ce magnétron, on aura un dépôt quasiment analogue à celui obtenu par la mise en oeuvre de la technique PACVD pure et composé par exemple d'oxyde.

Du fait que les substrats qui se déplacent sous les magnétrons passant successivement sous des magnétrons de densités de puissance croissantes, on peut ainsi obtenir le dépôt d'une couche présentant un gradient continu de composition passant depuis l'entrée de l'enceinte jusqu'à sa sortie par exemple d'une couche étanche à une couche dure avec toutes les couches de composition intermédiaire entre ces deux états.

La couche à gradient de composition déposée par mise en oeuvre simultanée des deux techniques de dépôt physique en phase vapeur PVD et de dépôt chimique en phase vapeur peut à elle seule constituer la totalité du revêtement déposé sur le substrat qui est alors un revêtement monocouche d'une épaisseur de préférence de 0,1 à 20 µm, de préférence encore de 2 à 5 µm. Un tel revêtement dans le cas où il s'agit d'un revêtement pour pièces métalliques présente déjà des propriétés anti-usure et anticorrosion satisfaisantes.

Il est également possible, selon l'invention, de réaliser un revêtement à plusieurs couches ou multicouches sur un substrat, afin notamment de communiquer à ce substrat des propriétés anticorrosion et anti-usure améliorées, l'une au moins de ces couches formant l'empilement des couches étant une couche à gradient de composition élaborée par mise en oeuvre simultanée des deux techniques de dépôt physique en phase vapeur (PVD) et de dépôt chimique en phase vapeur assisté par plasma (PACVD) de la manière décrite ci-dessus.

Le nombre de couches d'un tel revêtement multicouche est variable ; il peut aller de deux jusqu'à un nombre élevé limité seulement par le coût du procédé et la nature de l'application, par exemple 100, 1000, etc. Toutes les combinaisons sont possibles en ce qui concerne la nature de chacune des couches déposées, la technique mise en oeuvre pour le dépôt de chacune des couches, ainsi que pour l'alternance des diverses couches, ces couches pouvant notamment être déposées par les techniques de PVD, PACVD, ou par la mise en oeuvre simultanée des deux techniques PACVD/PVD, ou même éventuellement par d'autres techniques de dépôt connues de l'homme du métier et convenant à l'obtention des couches voulues à la condition toutefois qu'au moins une des couches soit élaborée par la technique de mise en oeuvre simultanée PVD/PACVD de l'invention. Les diverses couches ont une épaisseur de préférence comprise entre 0,01 µm et 10 µm, de préférence encore entre 0,1 et 5 µm.

De préférence, la couche déposée par la technique de mise en oeuvre simultanée des deux techniques PVD et PACVD est une couche intermédiaire ou de transition, c'est-à-dire que la couche déposée par cette mise en oeuvre simultanée est de préférence une couche qui n'est ni la première couche déposée sur le substrat lui-même, ni la couche supérieure de l'empilement de couches formant le revêtement multicouches.

De préférence, le revêtement multicouche préparé peut comprendre, sur un substrat, tel que par exemple un substrat métallique, trois couches : la première couche appliquée sur le substrat étant de préférence une couche dure déposée par PVD et composée par exemple de CrC ou de TiN ou de carbonitrure d'un métal de transition ou de silicium, et d'une épaisseur de préférence de 1 à 5 µm, la deuxième étant de préférence une couche à gradient de composition obtenue par mise en oeuvre simultanée des deux techniques PVD/PACVD et d'une épaisseur de préférence de 1 à 2 µm, cette couche commençant avec pratiquement 100 % de PVD (par exemple CrC ou TiN) et très peu de PACVD, et se terminant pratiquement avec 100 % de PACVD et 0 % de PVD - cette couche à gradient est donc une ccuche composée d'un matériau déposé par PVD qui est de préférence le matériau de la couche dure et d'un matériau déposé par PACVD qui est de préférence un oxyde de métal ou de métalloïde - ,et la troisième couche étant une couche étanche déposée par PACVD et composée par exemple d'un oxyde de métal ou de métalloïde tel que SiO₂, Al₂O₃ ou ZrO₂, qui est de préférence le même que celui de la couche à gradient, cette troisième couche ayant une épaisseur de préférence comprise entre 0,2 et 1,5 µm.

Ou bien, dans une configuration à trois couches, la première couche appliquée sur le substrat peut être une couche étanche déposée par PACVD composée par exemple d'oxyde de métal ou de métalloïde tel que SiO₂, Al₂O₃, ou ZrO₂ et d'une épaisseur de préférence de 0,2 µm à 1,5 µm, la deuxième couche est une couche à gradient de composition obtenue par mise en oeuvre simultanée des deux techniques PVD et PACVD, cette couche commençant avec pratiquement 100 % de PACVD-c'est-à-dire par un dépôt par exemple d'oxyde de métal ou de métalloïde tel que SiO₂ cet oxyde étant de préférence le même que celui de la couche étanche déposée par PACVD - et se terminant pratiquement à 100 % de PVD et 0 % de PACVD, et la troisième couche est une couche dure déposée par PVD composée de préférence du même matériau que celui déposé par PVD dans la couche à gradient de composition, par exemple de CrC ou de TiN, et d'une épaisseur de préférence de 1 à 5 µm. En outre, le revêtement multicouche selon l'invention peut également comprendre un empilement périodique de ces trois couches.

Le revêtement multicouche peut aussi, sur un substrat tel que par exemple un substrat métallique comprendre deux couches, la première étant une couche étanche déposée par PACVD, par exemple en oxyde de métal ou de métalloïde tel qu'en SiO₂, d'une épaisseur par exemple de 1 à 5 µm et la seconde couche, ou couche externe, étant une couche "dure" déposée par la mise en oeuvre simultanée des deux techniques de PVD et PACVD (le matériau déposé par PACVD étant par exemple un oxyde de métal ou de métalloïde, de préférence le même oxyde que celui composant la couche étanche) et ayant une épaisseur de préférence de 1 à 2 µm qui contient au départ principalement par exemple du Si et à la fin principalement par exemple du CrC à 100 %. Le revêtement multicouche selon l'invention peut également comprendre un empilement périodique de ces deux couches.

Dans ces revêtements multicouche, les couches réalisées par dépôt physique en phase vapeur (PVD) sont des couches possédant d'excellentes propriétés anti-usure.

Ces dépôts PVD de matériaux anti-usure sont effectués par des techniques de dépôt traditionnelles : magnétron, diode, et peuvent également être effectuées par évaporation.

La technique préférée et qui est la plus facile à mettre en oeuvre pour l'application particulière au revêtement anti-usure de pièces métalliques, est la technique magnétron. Cette technique présente de nombreux avantages tels qu'une grande souplesse, une grande versatilité, la possibilité de faire des dépôts en mode réactif (voir les documents DE-A-4 343 354 et EP-A-0 307 675), une vitesse de dépôt élevée, rendant possible une mise en oeuvre en continu du procédé ; les dépôts sur des tiges d'amortisseur par exemple peuvent se faire "au défilé". Pour les dépôts magnétron, la vitesse de dépôt varie linéairement avec la densité de puissance appliquée à la cible. Cette vitesse de dépôt peut par exemple être de l'ordre de 0,5µm/min. La pression de travail est de préférence de l'ordre de 0,05 mb à 0,03 mb (3 à 5 Pa).

Les matériaux durs pouvant constituer cette couche sont choisis par exemple parmi les carbures, nitrures, borures, les composés binaires tels que les carbonitrures et les composés ternaires, les solutions solides de carbure ou de nitrure, de métaux tels que Ti, Zr, Cr, Ta, Mo, HF, Nb, V et les composés tels que B₄C, BN, SiC, Si₃N₄, TiAlN.

De tels matériaux peuvent être élaborés par pulvérisation cathodique réactive en atmosphère CₓH_{y} par exemple CH₄, C₂H₂, C₂H₄, azote, diborane (voir les documents DE-A-4 343 354 et EP-A-0 307 675) ou à partir de cibles ayant déjà la composition souhaitée du dépôt : par exemple, la cible pourra être réalisée en CrC.

La Figure 2 représente une enceinte permettant de réaliser le dépôt de ces couches dures par la technique PVD. Dans cette enceinte se trouvent de manière classique des magnétrons (21) et des cibles en matériau à déposer, ainsi que le ou les substrat(s) à revêtir (22). Ces substrats sont déplacés par un dispositif de transport adéquat ou porte-échantillons (23), mobile de préférence dans les deux sens. Ce dispositif permet par exemple le transport des substrats en translation-rotation. Ce dispositif de transport peut être analogue à celui déjà décrit dans le cadre de la Fig. 1. L'enceinte reçoit par le piquage (24) par exemple du gaz Argon ainsi qu'éventuellement par le piquage (25) un gaz réactif dans le cas où l'on souhaite pulvériser des corps composés.

L'enceinte est reliée pour réaliser le vide nécessaire par exemple à un groupe de pompage à deux étages primaire et secondaire (26).

Les couches réalisées par dépôt chimique en phase vapeur assisté par plasma (PACVD) sont des dépôts étanches qui sont réalisés à basse fréquence, par exemple 50kHz. Les dépôts sont généralement réalisés à température ambiante et la pression de travail est comprise de préférence entre 0,05 et 1 mbar (5 et 100 Pa), les épaisseurs de dépôt sont en général de l'ordre de 0,2 à 1µm.

Les précurseurs des dépôts PACVD peuvent être par exemple des organosiliciés tels que l'hexaméthyldisiloxane, l'hexaméthyldisilazane, le tétraméthylsilane, des alcoxydes de métaux de transition Ti, Zr, Hf, V, Ta., d'alcoxyde d'aluminium tel que l'aluminium isopropoxyde etc.

Les matériaux destinés à être utilisés comme couches étanches et formés par décomposition des matériaux précurseurs cités ci-dessus sont par exemple du type oxyde de métal ou de métalloïde tels que SiO₂, ZrO₂, Al₂O₃, Tio₂, HfO₂, oxydes de vanadium ou des, polymère de type plasma. Les oxydes peuvent présenter des écarts à la stoechiométrie. On peut obtenir par exemple des dépôts de SiOx, x étant inférieur ou égal à 2.

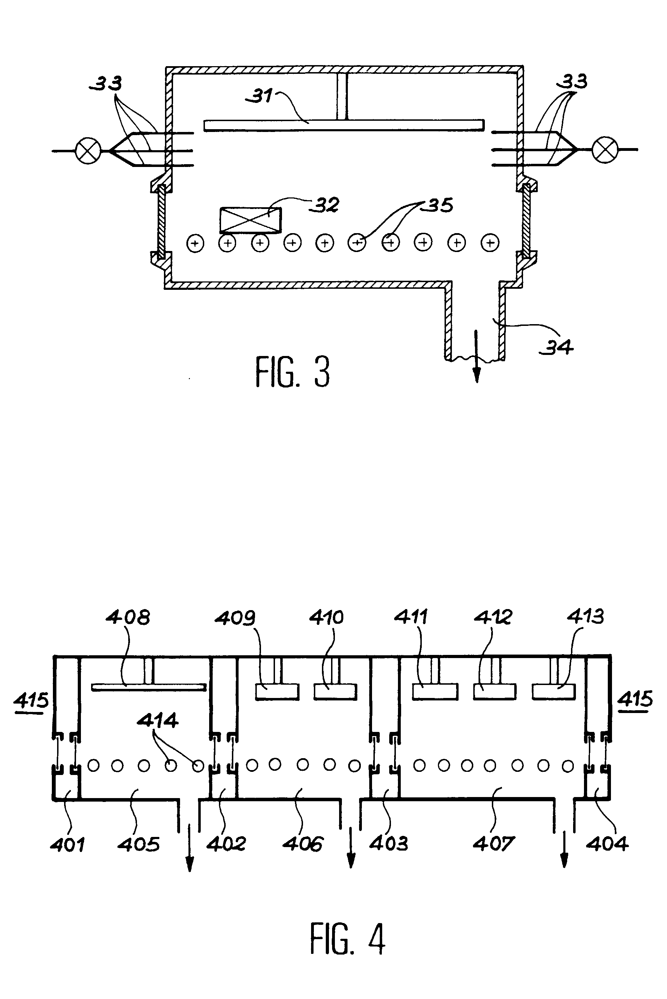

La figure 3 représente une enceinte permettant de réaliser le dépôt des couches étanches par la technique de dépôt chimique en phase vapeur assisté au plasma (PACVD) . Dans cette enceinte sont placés, de manière classique, une contre-électrode (31) ainsi que le ou les substrat (si à revêtir (32). L'enceinte est alimentée en gaz des précurseurs (33). Le vide est réalisé par exemple par un système de pompage, par exemple de type ROOTS (34). L'enceinte comprend également un dispositif de transport (35), par exemple de type analogue à ceux décrits dans les Fig. 1 et 2.

La figure 4 représente un exemple d'une installation permettant l'élaboration en continu de revêtements multicouches complexes comprenant une pluralité de couches dont l'une au moins, de préférence la couche intermédiaire est une couche à gradient de composition réalisée par la mise en oeuvre simultanée des deux techniques PVD et PACVD. Une telle installation permet de réaliser en particulier des revêtement anti-usure et anticorrosion de pièces métalliques diverses, en particulier de tiges d'amortisseurs pour automobiles.

Cette installation est en fait constituée de l'assemblage de divers modules constitués chacun par des appareils analogues aux appareils déjà décrits sur les figures 1, 2 et 3 entre lesquels sont interposés des sas différentiels.

Cette installation telle qu'illustrée sur la figure 4, qui ne représente qu'une forme possible de réalisation de l'installation selon l'invention comprend donc par exemple trois chambres successives, il est bien évident que le nombre des chambres, leur ordre, ainsi que la nature des procédés de dépôt mis en oeuvre dans chacune de ces chambres peut varier notamment en fonction du substrat revêtu et des propriétés à communiquer à ce substrat. Ces trois chambres sont successivement : une chambre de dépôt par PACVD permettant par exemple un dépôt d'une couche étanche en SiOₓ (405), une chambre de dépôt d'une couche à gradient par la mise en oeuvre simultanée des deux techniques PVD/PACVD (406) et enfin une chambre de dépôt par PVD (407).

L'ensemble de l'installation est séparé de l'air extérieur (415) par des sas différentiels (401) et (404), de même des sas différentiels (402) et (403) sont interposés entre les divers modules (405) (406) et (407), les sas différentiels permettant d'ajuster progressivement la pression pour atteindre la pression du procédé.

Le substrat à revêtir, par exemple, est acheminé dans l'installation depuis son entrée à l'aide d'un dispositif transporteur (414) : il s'agit dans le cas présent de rouleaux et traverse tout d'abord la chambre (405) dans laquelle le vide est réalisé par exemple par un système de pompage "roots", cette chambre est munie d'une contre-électrode (408) pour le revêtement par le procédé PACVD, qui permet le dépôt sur le substrat par exemple d'une couche de SiOₓ notamment de SiO₂. Pour les conditions de ce dépôt, on se référera à la description détaillée de la technique de dépôt PACVD par exemple en référence à la Fig. 3.

Le substrat traverse ensuite la chambre (406) de dépôt d'une couche à gradient de composition par la mise en oeuvre simultanée des deux techniques PVD et PACVD, dans laquelle le vide est réalisé par exemple à l'aide d'un pompage secondaire turbo moléculaire. Cette chambre fonctionne de la même manière que l'enceinte déjà décrite sur la figure 1 et comporte des cathodes magnétrons (409, 410) de densités de puissance différentes de préférence de densités de puissance croissantes, moyennant quoi une couche à gradient de composition est obtenue sur le substrat revêtu de la couche obtenu par PACVD en provenance de la chambre (405). Enfin, le substrat obtenu à l'issue de son traitement dans la chambre (406) est acheminé, dans ce qui constitue dans le cas de l'installation représentée sur la figure 4, une dernière chambre de dépôt (407), cette chambre dans laquelle le vide est réalisé de la même manière que dans la chambre (406), est équipée par exemple de magnétrons (411), (412), (413) pour réaliser sur le substrat issu de l'enceinte (406) un dépôt par exemple de CrC. Les chambres (406) et (407) peuvent bien entendu comporter un dispositif de transport analogue à celui des chambres précédentes.

En outre, il est possible, dans l'installation de la figure 4 de faire circuler le substrat en sens inverse ; l'ordre des couches déposées sera alors inversé ; cette souplesse de mise en oeuvre constitue un des avantages supplémentaires apportés par ce procédé selon l'invention dans le cas où l'on procède au dépôt d'un revêtement multicouches.

Il est bien évident que d'autres assemblages des divers modules individuels sont possibles. A savoir, on pourra par exemple dans une installation à deux modules, commencer par déposer sur le substrat une couche PACVD étanche, par exemple une couche de SiO₌, puis déposer une seconde couche PACVD/PVD.

Les exemples suivants illustrent le procédé de l'invention :
**Exemple 1** : Préparation d'un revêtement à trois couches comprenant une couche dure de Cr-C déposée par PVD, une couche à gradient de composition CrC-SiOₓ, et une couche étanche de SiOₓ déposée par PACVD.

Après un décapage ionique magnétron basse fréquence (100 kHz) en plasma argon sous une densité de puissance de 3 W/cm² et une polarisation de l'ordre de -500 Volts, un acier au carbone (tige d'amortisseur automobile) est recouvert d'un film mince de Cr-C d'une épaisseur de l'ordre de 2µm par pulvérisation cathodique magnétron DC. Les vitesses de croissance sont de l'ordre de 0,5 µm/h. La pression de travail est de 5 10⁻³ mbar, le gaz est de l'argon. Le substrat défile ensuite sous plusieurs cathodes magnétron sur lesquelles on impose une densité de puissance variable, à savoir de 10 W/cm² à 1 W/cm² .Le mélange gazeux est alors constitué d'argon, d'hexaméthyldisiloxane et d'oxygène dans les proportions suivantes : 5/1/1 Les cibles de pulvérisation sont en carbure de chrome. Le substrat se recouvre progressivement d'une couche à gradient de composition d'une épaisseur comprise entre 0,5 et 1 um. Enfin, dans la troisième chambre de dépôt, le substrat est recouvert d'un film de SiOₓ, par PACVD basse fréquence (50 kHz) à partir d'un mélange gazeux d'hexaméthyldisiloxane et oxygène dans des proportions telles que, la pression totale dans le réacteur étant de 0,2 mbar, le rapport des pressions partielles des réactifs est : P (HMDS)/P (O₂) = 1/5. La densité de puissance électrique est de 0,5 W/cm². Une mesure d'impédance électrochimique en milieu Nacl 30 g/l montre une amélioration d'un facteur 10 de la résistance de polarisation par rapport à un dépôt de Cr-C réalisé par pulvérisation cathodique.
**Exemple 2** : Préparation d'un revêtement à deux couches comprenant une couche étanche de SiOₓ, déposée par PACVD et une couche à gradient de composition SiOₓ-CrC déposée par mise en oeuvre simultanée des deux techniques PACVD-PVD.

Après un décapage ionique basse fréquence (100 kHz) en plasma argon sous une densité de puissance de 3 W/cm², une polarisation de l'ordre de -1000 Volts et une pression de 0,2 mbar, un acier au carbone formant une tige d'amortisseur automobile est recouvert d'un film mince de SiOₓ d'une épaisseur de l'ordre de 0,25 µm par PACVD basse fréquence à partir d'un mélange hexaméthyldisiloxane/oxygène dans le rapport 1/5. La pression totale est de 0,2 mbar, la densité de puissance électrique est de 0,5 W/cm². Le substrat défile ensuite sous plusieurs cathodes magnétron sur lesquelles on impose une densité de puissance variable croissante, à savoir de 1 W/cm² à 10 W/cm². Le mélange gazeux est alors constitué d'argon et de tétraméthylsilane dans les proportions suivantes : 5/1 Les cibles de pulvérisation sont en carbure de chrome. Le substrat se recouvre progressivement d'une couche à gradient de composition d'une épaisseur comprise entre 1,5 et 2 µm.
**Exemple 3** : Préparation d'un revêtement à trois couches comprenant une couche dure de Cr-C déposée par PVD, une couche à gradient de composition CrC-Al₂O₃ déposée par mise en oeuvre simultanée des deux techniques PACVD-PVD, et une couche étanche de Al₂O₃ déposée par PACVD.

Après un décapage ionique magnétron basse fréquence (100 kHz) en plasma argon sous une densité de puissance de 3 W/cm² et une polarisation de l'ordre de -500 Volts, un acier au carbone (tige d'amortisseur automobile) est recouvert d'un film mince de Cr-C d'une épaisseur de l'ordre de 2 µm par pulvérisation cathodique magnétron DC. Les vitesses de croissance sont de l'ordre de 0,5 µm/h. La pression de travail est de 5 10⁻³ mbar, le gaz est de l'argon. Le substrat défile ensuite sous plusieurs cathodes magnétron sur lesquelles on impose une densité de puissance variable, à savoir de 10 W/cm² à 1 W/cm² Le mélange gazeux est alors constitué d'argon, d'aluminium iso-propoxyde (Al-O-iPr), et d'oxygène dans les proportions suivantes 5/1/1. Les cibles de pulvérisation sont en chrome. Le substrat se recouvre progressivement d'une couche à gradient de composition d'une épaisseur comprise entre 0,5 5 et 1 µm. Enfin, dans la troisième chambre de dépôt, le substrat est recouvert d'un film de Al₂O₃ par PACVD basse fréquence (50 kHz) à partir d'un mélange gazeux d'aluminium-isopropoxyde et oxygène. La pression totale dans le réacteur est de 0,2 mbar, et le rapport des pressions partielles des réactifs est : P(Al-O-iPr)/P (O₂) = 1/5. La densité de puissance électrique est de 0,5 W/cm², Une mesure d'impédance électrochimique en milieu NaCl 30 g/l montre une amélioration d'un facteur 15 de la résistance de polarisation par rapport à un dépôt de CrC réalisé par pulvérisation cathodique.
**Exemple 4** : Préparation d'un revêtement à trois couches comprenant une couche dure de TiN déposée par PVD, une couche à gradient de composition TiN-SiOₓ déposée par mise en oeuvre simultanée des deux techniques PACVD-PVD, et une couche étanche de SiOₓ déposée par PACVD.

Après un décapage ionique magnétron basse fréquence (100 kHz) en plasma argon sous une densité de puissance de 3 W/cm² et une polarisation de l'ordre de -500 Volts, un acier au carbone formant une tige d'amortisseur automobile est recouvert d'un film mince de TiN d'une épaisseur de l'ordre de 2 µm par pulvérisation cathodique magnétron DC réactive à partir d'une cible en titane. Les vitesses de croissance sont de l'ordre de 0,5 µm/h. La pression de travail est de 5.10⁻³ mbar, le gaz est un mélange d'argon et d'azote dans les proportions de 5/1. Le substrat défile ensuite sous plusieurs cathodes magnétron sur lesquelles on impose une densité de puissance variable, à savoir de 10 W/cm² à 1 W/cm² Le mélange gazeux est alors constitué d'argon, d'hexaméthyldisiloxane, et d'oxygène dans les proportions de 5/1/1. Les cibles de pulvérisation sont en nitrure de titane. Le substrat se recouvre progressivement d'une couche à gradient de composition d'une épaisseur comprise entre 0,5 et 1 µm. Enfin, dans la troisième chambre de dépôt, le substrat est recouvert d'un film de SiOₓ par PACVD basse fréquence (50 kHz) à partir d'un mélange gazeux hexaméthyldisiloxane et oxygène. La pression totale dans le réacteur est de 0,2 mbar, et le rapport des pressions partielles des réactifs est : P(HMDS)/P O₂) = 1/5. La densité de puissance électrique est de 0,5 W/cm².

## Revendications

1. Procédé de dépôt d'un revêtement sur un substrat caractérisé en ce que ce revêtement comprend au moins une couche à gradient de composition déposée par mise en oeuvre simultanée des deux techniques de dépôt physique en phase vapeur PVD et de dépôt chimique en phase vapeur assisté par plasma PACVD.

2. Procédé selon la revendication 1, caractérisé en ce que le substrat est un substrat en métal, en matériaux plastiques ou en matériaux composites.

3. Procédé selon la revendication 2, caractérisé en ce que le substrat est une tige d'amortisseur pour automobiles.

4. Procédé selon la revendication 1, caractérisé en ce que le revêtement est un revêtement multicouches qui comprend en outre des couches déposées par dépôt chimique en phase vapeur assisté par plasma, et des couches déposées par dépôt physique en phase vapeur.

5. Procédé selon la revendication 4, caractérisé en ce que le revêtement comprend trois couches.

6. Procédé selon la revendication 5, caractérisé en ce que la première couche appliquée sur le substrat est une couche dure déposée par dépôt physique en phase vapeur, la deuxième couche est une couche à gradient de composition déposée par mise en oeuvre simultanée des deux techniques de dépôt physique en phase vapeur et de dépôt chimique en phase vapeur assisté par plasma et la troisième couche est une couche étanche déposée par dépôt chimique en phase vapeur assisté par plasma.

7. Procédé selon la revendication 6 caractérisé en ce que la couche à gradient de composition est composée du matériau de la couche dure et d'un oxyde de métal ou de métalloïde, et en ce que la couche étanche est une couche de cet oxyde de métal ou de métalloïde.

8. Procédé selon la revendication 4, caractérisé en ce que le revêtement comprend deux couches.

9. Procédé selon la revendication 8, caractérisé en ce que la première couche appliquée sur le substrat est une couche étanche déposée par dépôt chimique en phase vapeur assisté par plasma et la seconde couche est une couche à gradient de composition déposée par mise en oeuvre simultanée des deux techniques de dépôt physique en phase vapeur et de dépôt chimique en phase vapeur assisté par plasma.

10. Procédé selon la revendication 9 caractérisé en ce que la couche étanche est une couche d'oxyde de métal ou de métalloïde et en ce que la couche à gradient de composition est composée de cet oxyde et d'un matériau déposé par dépôt physique en phase vapeur

11. Procédé selon la revendication 1, caractérisé en ce que le gradient de composition de la couche à gradient de composition est obtenu en faisant varier la densité de puissance mise en oeuvre dans la technique de dépôt physique en phase vapeur.

12. Revêtement caractérisé en ce qu'il est obtenu par le procédé selon l'une quelconque des revendications 1 à 11.

13. Substrat recouvert d'un revêtement, caractérisé en ce que ledit revêtement a été déposé par le procédé selon l'une quelconque des revendications 1 à 11.

14. Revêtement caractérisé en ce qu'il comprend au moins une couche à gradient de composition déposée par mise en oeuvre simultanée des deux techniques de dépôt physique en phase vapeur PVD et de dépôt chimique en phase vapeur assisté par plasma PACVD.

15. Revêtement selon la revendication 14, caractérisé en ce que ledit revêtement est un revêtement multicouches qui comprend en outre des couches déposées par dépôt chimique en phase vapeur assisté par plasma, et des couches déposées par dépôt physique en phase vapeur.

16. Revêtement selon la revendication 15, caractérisé en ce que ledit revêtement comprend trois couches.

17. Revêtement selon la revendication 16, caractérisé en ce que la première couche dudit revêtement appliquée sur un substrat est une couche dure déposée par dépôt physique en phase vapeur, la deuxième couche est une couche à gradient de composition déposée par mise en oeuvre simultanée des deux techniques de dépôt physique en phase vapeur et de dépôt chimique en phase vapeur assisté par plasma et la troisième couche est une couche étanche déposée par dépôt chimique en phase vapeur assisté par plasma.

18. Revêtement selon la revendication 17 caractérisé en ce que la couche à gradient de composition est composée du matériau de la couche dure et d'un oxyde de métal ou de métalloïde, et en ce que la couche étanche est une couche de cet oxyde de métal ou de métalloïde.

19. Revêtement selon la revendication 15, caractérisé en ce que ledit revêtement comprend deux couches.

20. Revêtement selon la revendication 19, caractérisé en ce que la première couche dudit revêtement appliquée sur un substrat est une couche étanche déposée par dépôt chimique en phase vapeur assisté par plasma et la seconde couche est une couche déposée par mise en oeuvre simultanée des deux techniques de dépôt physique en phase vapeur et de dépôt chimique en phase vapeur assisté par plasma.

21. Revêtement selon la revendication 20 caractérisé en ce que la couche étanche est une couche d'oxyde de métal ou de métalloïde et en ce que la couche à gradient de composition est composée de cet oxyde et d'un matériau déposé par dépôt physique en phase vapeur

22. Substrat recouvert d'un revêtement selon l'une quelconque des revendications 14 à 20.

23. Substrat selon la revendication 22, caractérisé en ce que ledit substrat est un substrat en métal, en matériaux plastiques ou en matériaux composites.

24. Substrat selon la revendication 23, caractérisé en ce que ledit substrat est une tige d'amortisseur pour automobiles.
